# DEMANDE DE BREVET EUROPEEN

(11) **EP 0 581 702 A1**
(43) Date de publication de la demande: **02.02.1994**
(21) Numéro de dépôt: 93420321.7
(22) Date de dépôt: 27.07.1993
(51) Int. Cl.: H01L 27/08, H01L 29/94

(54) **Condensateur en technologie CMOS**

(30) Priorité: 30.07.1992 FR 9209796
(71) Demandeur: SGS-THOMSON MICROELECTRONICS S.A., F-94250 Gentilly (FR)
(72) Inventeur: Fensch, Thierry, F-38000 Grenoble (FR)
(74) Mandataire: de Beaumont, Michel

(57) **Abrégé**

La présente invention concerne un condensateur de circuit intégré de type CMOS, ce circuit comprenant un substrat d'un premier type de conductivité (3) dans lequel sont formés des caissons du deuxième type de conductivité dont une partie est surmontée d'une grille isolée. Ce condensateur est formé dans deux caissons identiques (31, 41) surmontés de grilles identiques (32, 42). Chaque caisson comprend une région du deuxième type de conductivité (33, 43) à haut niveau de dopage s'étendant sensiblement entre la projection de la grille et le voisinage de la périphérie du caisson. Chaque grille d'un caisson est connectée à la région du deuxième type de conductivité de l'autre caisson et constitue une électrode du condensateur.

## Description

La présente invention conoerne le domaine des circuits intégrés, et plus particulièrement la réalisation de condensateurs dans des circuits intégrés de type CMOS à un seul niveau de grille.

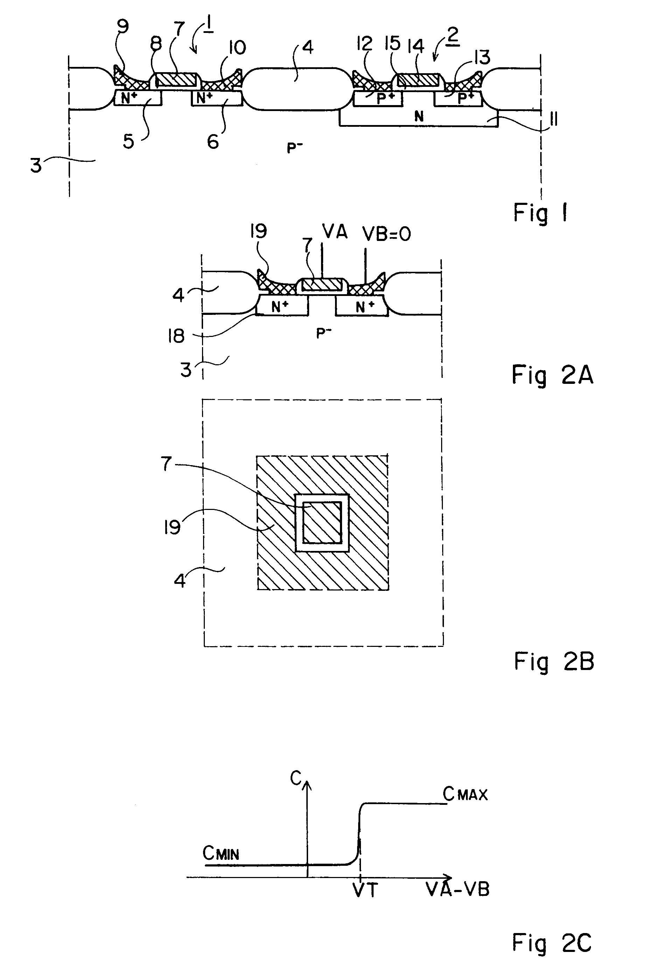

A titre de rappel, la figure 1 représente un transistor 1 à canal N et un transistor 2 à canal P constituant les composants de base d'un circuit intégré CMOS.

Le transistor 1 à canal N est directement formé dans un substrat 3 de type P faiblement dopé (P-). Le transistor à canal N comprend, dans une zone délimitée par une couche d'oxyde épais 4, des régions de drain et de source 5 et 6 disjointes et formees de part et d'autre d'une région de canal qui s'étend sous une région de grille 7 isolée par une couche d'oxyde mince 8. Des métallisations 9 et 10 sont respectivement en contact avec les régions de drain et de source 5 et 6.

Le transistor 2 à canal P est formé dans un caisson de type N faiblement dopé 11 lui-même formé dans le substrat dans une zone délimitée par une couche d'oxyde épais. Ce transistor comprend des régions de drain et de source 12 et 13 séparées par une région de canal s'étendant sous une grille 14 isolée par une couche d'oxyde mince 15.

Bien entendu, la figure 1 est très schématique et, comme cela est connu, chacun de ses éléments est susceptible de nombreuses variantes de réalisation. Par exemple, d'autres modes de prise de contact que des métallisations peuvent être prévus pour assurer les contacts de drain et de source. Les grilles 7 et 14 sont couramment constituées d'une couche de silicium polycristallin à la surface supérieure de laquelle est parfois formé un siliciure d'un métal réfractaire.

La structure décrite ci-dessus est classiquement appelée structure CMOS à caisson N. En effet, dans cette structure le substrat est de type P et les transistors à canal P sont formés dans des caissons N. Inversement, si le substrat était de type N on parlerait de technologie à caisson P et ce serait les transistors à canal N qui seraient formés dans des caissons P eux-mêmes formés dans le substrat de type N.

On distingue également les diverses technologies par le nombre de couches de métallisation et de silicium polycristallin qui sont formées. Dans une technologie simple telle que celle représentée en figure 1, dans laquelle existent simplement des transistors MOS à grille unique, il existe une seule couche de silicium polycristallin dans laquelle sont gravées toutes les grilles qui servent ensuite à délimiter les implantations de source et de drain. Il existe en plus généralement deux ou trois niveaux de métallisation : le niveau de métallisation représenté sur la figure servant à la prise de contact sur les régions de source et de drain et un deuxième niveau de métallisation servant à réaliser les interconnections nécessaires entre les divers transistors élémentaires du circuit intégré pour former les circuits souhaités.

On distingue aussi les diverses technologies ou filières de fabrication selon le nombre de types de transistors que l'on peut obtenir. Dans la structure représentée, il existe un seul type de transistor à canal N et un seul type de transistor à canal P formé dans un caisson, tous deux à enrichissement. En effet, dans les technologies simples, il n'est pas prévu d'étapes d'implantation distinctes dans le substrat sous certaines grilles avant formation de celles-ci. Il est prévu tout au plus une étape d'implantation générale du substrat avant dépôt du silicium polycristallin de grille. Dans ce cas, il existe un seul type de transistor à canal N et un seul type de transistor à canal P, comme cela est représenté en figure 1.

Si l'on veut réaliser un condensateur dans un circuit intégré, il existe a priori plusieurs possibilités. On peut examiner toutes les solutions dans lesquelles la technologie permet d'obtenir de part et d'autre d'une couche isolante deux régions conductrices. Ainsi, de façon générale, ces possibilités sont les suivantes.
- Formation d'un condensateur entre deux niveaux de silicium polycristallin. De tels condensateurs sont généralement satisfaisants car la couche d'oxyde prévue entre deux niveaux de silicium polycristallin, qui correspond à une couche isolante entre grille flottante et grille de commande, est une couche de petite épaisseur dont les paramètres sont nécessairement fixés avec précision dans la technologie considérée. Ceci permet de fournir des condensateurs de relativement forte valeur pour une surface donnée mais on se place ici dans le cadre d'une technologie où il n'existe qu'un seul niveau de silicium polycristallin et qui ne permet pas l'obtention de tels condensateurs.
- Réalisation d'un condensateur entre la couche de silicium polycristallin et une zone sous- jacente fortement dopée du substrat ou d'un caisson. L'isolant d'un tel condensateur serait constitué par un oxyde formé en même temps que l'oxyde de grille qui est un oxyde dont l'épaisseur est définie nécessaire- ment avec précision dans une technologie donnée. A nouveau, la réalisation d'un tel condensateur n'est pas possible dans la technologie envisagée où il n'existe pas de possibilité de surdopage d'un substrat ou d'un caisson sous une région de grille particulière avant formation de la grille.
- Réalisation d'un condensateur entre une couche métallique et une autre couche métallique ou une couche de silicium polycristallin. La réalisation d'un tel condensateur est envisageable dans la technologie simple considérée. Néanmoins, de tels condensateurs auraient nécessairement une surface importante pour une valeur de capacité donnée puisque les couches isolantes destinées à séparer deux métallisations ou une métallisation d'un niveau de silicium polycristallin sont nécessaire- ment épaisses. En effet, en dehors des emplacements où l'on souhaite réaliser des condensateurs, on souhaite que les capacités inter-métallisations ou entre métallisation et silicium polycristallin soient aussi faibles que possible car elles constituent des capacités parasites qui limitent la vitesse de fonctionnement d'un dispositif. En outre, ces couches isolantes ont généralement des épaisseurs qui ne sont pas définies avec une forte précision car, pour les autres fonctions du circuit, leur épaisseur n'est pas critique.

Ainsi, dans le cadre de la technologie simple envisagée, on réalise généralement des condensateurs de la façon illustrée schématiquement en coupe en figure 2A et en vue de dessus en figure 2B. Le condensateur est constitué exactement comme un transistor MOS à canal N sauf que son drain et sa source forment une seule et même région 18 et qu'il existe une seule métallisation 19 constituant une électrode du condensateur et correspondant à la connexion des métallisations de source et de drain 9 et 10 de la figure 1. Ces figures 2Aet 2B ne sont pas décrites plus en détail car elles décrivent une structure connue et sont facilement compréhensibles de l'homme de métier. Pour simplifier leur lecture, de mêmes références qu'en figure 1 sont utilisées pour désigner des éléments analogues.

La courbe caractéristique d'un condensateur du type de celui des figures 2A-2B est illustrée en figure 2C, la grille 7 constituant la première électrode étant portée à un potentiel VA et la métallisation 19 constituant la deuxième électrode à un potentiel VB.

Comme le montre la figure 2C, la capacité du condensateur varie entre une valeur faible Cmin pour des valeurs négatives ou légèrement positives de la tension VA-VB et une valeur forte Cmax pour des valeurs positives de VA-VB. La transition a lieu pour une tension sensiblement égale à la tension de seuil VT d'un transistor MOS équivalent. Ainsi, un tel condensateur est d'utilisation peu souple puisque le potentiel de l'une de ses électrodes doit être supérieur au potentiel de son autre électrode d'un seuil déterminé (VT) pour que ce condensateur ait une capacité par unité de surface relativement élevée et stable. VB devant être positif ou nul pour assurer l'isolement de la région 18 par rapport au substrat, on choisira de préférence VB égal à zéro pour avoir une plage aussi grande que possible de variation de VA (VA est compris entre VB+VT et la tension d'alimentation la plus positive du circuit).

Ainsi, un objet de la présente invention est de former dans un circuit intégré de type CMOS un condensateur de valeur élevée par unité de surface et de capacité constante sur une large gamme de tensions aux bornes.

Un autre objet de la présente invention est de prévoir un tel condensateur dont le processus de fabrication n'implique pas d'étape supplémentaire par rapport aux étapes classiques de fabrication de transistors CMOS à un seul niveau de grille et sans implantations localisées sous les grilles.

Pour atteindre ces objets, la présente invention prévoit un condensateur de circuit intégré de type CMOS, ce circuit comprenant un substrat d'un pre- miertype de conductivité dans lequel sont formés des caissons du deuxième type de conductivité dont une partie est surmontée d'une grille isolée. Ce condensateur est formé dans l'un des caissons dont la grille correspond à une première électrode du condensateur, et comprend une région du deuxième type de conductivité à haut niveau de dopage s'étendant sensiblement entre la projection de la grille et le voisinage de la périphérie du caisson, cette région correspondant à la deuxième électrode du condensateur.

Selon un mode de réalisation de la présente invention, le condensateur est formé dans deux caissons identiques, chaque caisson comprenant une région du deuxième type de conductivité à haut niveau de dopage s'étendant sensiblement entre la projection de la grille et le voisinage de la périphérie du caisson, chaque grille d'un caisson étant connectée à ladite région de l'autre caisson et constituant une électrode du condensateur.

Selon un mode de réalisation de la présente invention, chacune desdites régions est une région annulaire s'étendant entre la grille et le bord d'un caisson.

Selon un mode de réalisation de la présente invention, chacune desdites régions est réalisée en même temps que les régions de drain et de source des transistors MOS à canal du deuxième type de conductivité.

Ces objets, caractéristiques, avantages ainsi que d'autres de la présente invention seront exposés en détail dans la description suivante de modes de réalisation particuliers faite en relation avec les figures jointes, parmi lesquelles :
la figure 1, précédemment décrite, représente une vue en coupe schématique de transistors CMOS;
les figures 2Aet 2B représentent respectivement une vue en coupe et une vue de dessus d'un condensateur de type grille/drain-source selon l'art antérieur ;
la figure 2C représente la caractéristique capacité/ tension du condensateur des figures 2A et 2B;
la figure 3A représente une vue en coupe d'un mode de réalisation d'un condensateur selon la présente invention ;
la figure 3B représente la caractéristique capacité/ tension du condensateur de la figure 3A ;
la figure 4A représente une vue en coupe d'un autre mode de réalisation d'un condensateur selon la présente invention ; et
la figure 4B représente la caractéristique capacité/ tension du condensateur de la figure 4A.

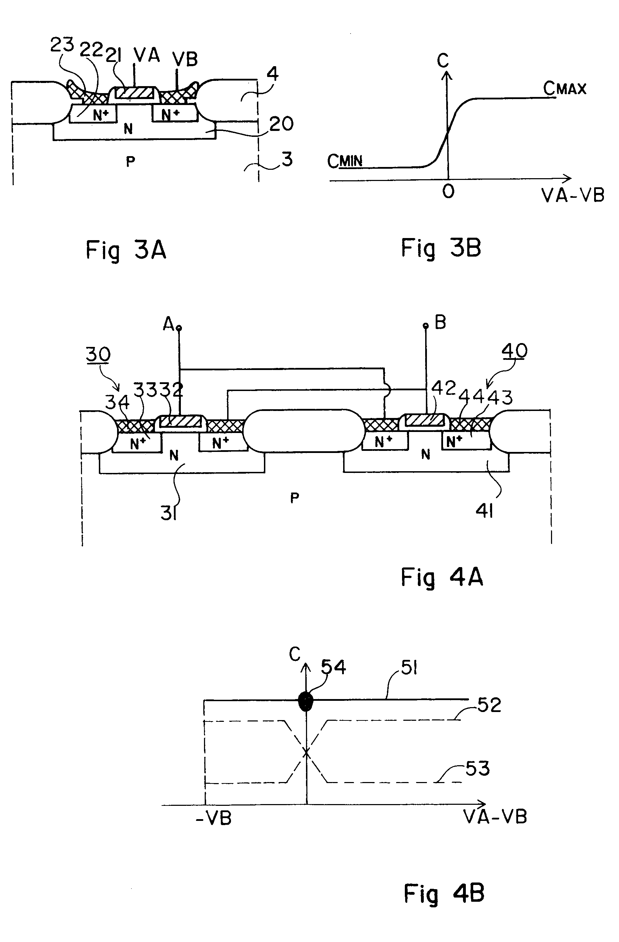

La figure 3A représente un caisson N délimité par une couche d'oxyde épais 4 et formé dans un substrat de type P faiblement dopé 3. Au dessus de ce caisson est formée une grille 21 ayant par exemple la forme de la grille 7 des figures 2A et 2B. Ensuite, est formée dans le caisson une région périphérique 22 de même type de conductivité que le caisson, c'est-à-dire de type N, à fort niveau de dopage. La capacité selon la présente invention est formée entre la grille 21 et une métallisation 23 ou autre couche de contact avec la région de type N⁺ 22. Si l'on applique une tension VA à la grille 21 et une tension VB à la métallisation 23, la caractéristique de la capacité en fonction de VA-VB a l'allure générale illustrée en figure 3B. Dans des conditions qui seront précisées ci-après, elle est symétrique par rapport à une valeur pour laquelle VA-VB = 0.

Le potentiel VB peut avoir toute valeur positive choisie propre à assurer la polarisation du caisson 20 par rapport au substrat. Ainsi, la tension VA peut prendre toute valeur supérieure à la valeur VB et on a alors une capacité sensiblement constante sauf au voisinage immédiat de la valeur VA = VB. Cette zone critique est peu gênante car en fait on est rarement intéressé par la linéarité d'un condensateur quand sa charge est nulle.

Toutefois, le condensateur de la figure 3A se comporte comme un condensateur polarisé, qui ne fonctionne bien que quand la tension sur l'une de ses électrodes (VA) présente une polarité donnée (positive) par rapport à la tension (VB) sur l'autre de ses électrodes.

La figure 4Areprésente une modification selon la présente invention de la structure de la figure 3A permettant d'obtenir un condensateur fonctionnant quelle que soit la polarité de l'une de ses électrodes par rapport à l'autre. Ce condensateur comprend deux cellules 30 et 40 respectivement identiques au condensateur élémentaire de la figure 3A. La première cellule comprend un caisson 31 au dessus duquel est formée une grille 32 entre la périphérie de laquelle et la périphérie du caisson s'étend une région de type N fortement dopée 33. De même, la cellule 40 comprend un caisson 41, une grille 42 et une région fortement dopée de type N⁺ 43. Les régions 33 et 43 sont respectivement revêtues de métallisations 34 et 44. La grille 32 est reliée à la métallisation 44 et la grille 42 est reliée à la métallisation 34. Des bornes A et B solidaires des grilles 32 et 42 constituent les deux bornes du condensateur selon l'invention.

En utilisation, il convient que les tensions VA et VB appliquées aux bornes A et B soient toujours positives pour que les caissons 31 et 41 restent isolés du substrat. Néanmoins, pour autant que cette condition est satisfaite, la différence de potentiel entre A et B peut être positive ou négative. On obtient alors un condensateur ayant la caractéristique désignée en figure 4B par la courbe 51 qui est constituée de la superposition des courbes 52 et 53 correspondant aux capacités de chacune des cellules. On voit que la valeur de la capacité est sensiblement constante, que VA-VB soit positif ou négatif (à condition toujours que VA et VB soient tous deux positifs).

La courbe 51 présente éventuellement un défaut dans la région 54 où VA est sensiblement égal à VB, mais comme on l'a vu précédemment, ce défaut est peu gênant puisqu'il correspond à une zone où la charge aux bornes du condensateur est nulle.

Dans ce qui précède, on a supposé que la caractérisation de la figure 3B était symétrique par rapport au point où elle coupe l'axe VA-VB=0, et en particulier que cette caractéristique n'est pas décalée vers la droite ou vers la gauche par rapport à cet axe, ce qui permet d'obtenir une valeur résultante constante telle que représentée par la droite 51 de la figure 4B. En pratique, cette symétrie est obtenue seulement si la structure est réalisée par un procédé convenable. Il faut notamment que
- le dopage des caissons 31 et 41 soit suffisamment élevé (par exemple supérieur à 8 10¹⁵ at/cm3),
- le silicium polycristallin de grille soit rendu conducteur par des atomes dopants de même type que ceux du caisson (ceci n'est pas toujours le cas dans certaines technologies à caisson P où la grille est dopée par des dopants de type N),
- la technologie soit telle qu'il existe peu de charges stockées dans les couches d'oxyde de grille.

L'homme de métier trouvera toute indication sur le choix de ces paramètres dans le livre "Microelec- tronic Devices", E.S. Yang, McGraw-Hill Book Company, 1988, P.236-244.

Le condensateur selon la présente invention peut être fabriqué sans modifier les étapes simples d'une technologie CMOS classique puisque les régions N⁺ formées dans le caisson N peuvent être réalisées en même temps que les régions N⁺ formées directement dans le substrat pour réaliser les transistors MOS à canal N.

Bien entendu les diverses figures sont fortement schématiques, les épaisseurs des couches ne sont pas à l'échelle et diverses variantes généralement utilisées pour la réalisation des transistors MOS pourront être mises en oeuvre pour réaliser et optimiser le condensateur selon la présente invention. La stucture décrite est notamment compatible avec des technologies dans lesquelles le silicium polycristallin de grille est revêtu d'un siliciure métallique.

Un autre avantage du condensateur selon la présente invention, comme cela a été exposé précédemment est que ses caractéristiques sont bien déterminées puisque sa valeur de capacité, plus particulièrement la valeur Cmax de la figure 3B, dépend essentiellement de l'épaisseur de la couche d'oxyde de grille qui est une caractéristique toujours contrôlée avec une très grande précision dans des dispositifs MOS.

Par contre, la valeur Cmin dépend du dopage du caisson. C'est une caractéristique qui est moins bien contrôlée mais ses variations ne sont pas prépondérantes puisque, dans le cas de la figure 3B, cette caractéristique n'est pas utilisée et, dans le cas de la figure 4B, c'est la plus petite des deux composantes qui rentre dans la valeur totale.

Dans une expérimentation effectuée par la demanderesse, avec un substrat de type N, une couche de grille ayant une surface de 10⁴ micromètres carrés, une épaisseur d'oxyde de grille de 24,3 nm, un niveau de dopage de caisson de 9x10¹⁵ ato- mes/cm³, on a obtenu une valeur Cmax de 14,17 pF et une valeur de Cmin de 2,60 pF pour une fréquence appliquée de l'ordre de 30 kHz.

## Revendications

1. Condensateur de circuit intégré de type CMOS, ce circuit comprenant un substrat d'un premier type de conductivité (3) dans lequel sont formés des caissons du deuxième type de conductivité dont une partie est surmontée d'une grille isolée, ce condensateur étant formé dans l'un desdits caissons (20) dont la grille (21) correspond à une première électrode du condensateur, ce condensateur étant caractérisé en ce qu'il comprend une région (22) du deuxième type de conductivité à haut niveau de dopage s'étendant sensiblement entre la projection de la grille et le voisinage de la périphérie du caisson, cette région (22) correspondant à la deuxième électrode du condensateur.

2. Condensateur de circuit intégré de type CMOS, ce circuit comprenant un substrat d'un premier type de conductivité (3) dans lequel sont formés des caissons du deuxième type de conductivité dont une partie est surmontée d'une grille isolée, caractérisé en ce qu'il est formé dans deux caissons identiques (31, 41) surmontés de grilles identiques, (32, 42), chaque caisson comprenant une région du deuxième type de conductivité (33, 43) à haut niveau de dopage s'étendant sensiblement entre la projection de la grille et le voisinage de la périphérie du caisson, chaque grille d'un caisson étant connectée à ladite région de l'autre caisson et constituant une électrode du condensateur.

3. Condensateur selon la revendication 1 ou 2, caractérisé en ce que chacune desdites régions est une région annulaire s'étendant entre la grille et le bord d'un caisson.

4. Condensateur selon la revendication 1 ou 2, caractérisé en ce que chacune desdites régions est réalisée en même temps que les régions de drain et de source des transistors MOS à canal du deuxième type de conductivité.

5. Condensateur selon la revendication 1 ou 2, caractérisé en ce que lesdites grilles sont en silicium polycristallin dopé selon le deuxième type de conductivité.
